Europäisches Patentamt

European Patent Office

Office européen des brevets

(19)

(11) Veröffentlichungsnummer: **0 005 165**
A1

(12) **EUROPÄISCHE PATENTANMELDUNG**

(21) Anmeldenummer: 79100949.1

(22) Anmeldetag: 29.03.79

(51) Int. Cl.²: **H 01 L 21/316,** H 01 L 21/88,
H 01 L 23/48

(30) Priorität: 02.05.78 US 902127

(43) Veröffentlichungstag der Anmeldung: 14.11.79
Patentblatt 79/23

(84) Benannte Vertragsstaaten: **DE FR GB**

(71) Anmelder: **International Business Machines
Corporation, Armonk, N.Y. 10504 (US)**

(72) Erfinder: **Garbarino, Paul Louis, 187 Barlow Mt. Rd.,
Ridgefield Connecticut 06877 (US)**
Erfinder: **Makarewicz, Stanley Richard, 17 Cherry
Avenue MD No. 23, New Windsor N.Y. 12550 (US)**
Erfinder: **Shepard, Joseph Francis, Country Club Road,
Hopewell Junction, N.Y. 12533 (US)**

(74) Vertreter: **Mönig, Anton, Dipl.-Ing., Schönaicher
Strasse 220, D-7030 Böblingen (DE)**

(54) **Verfahren zur Herstellung von isolierten Leitbereichen aus polykristallinem Silicium sowie entsprechend aufgebaute Halbleiteranordnungen mit Feldeffektelementen.**

(57) Im Rahmen eines Verfahrens zur Herstellung mit isolierten Leitbereichen aus polykristallinem Silicium ausgestatteter Halbleiteranordnungen mit Feldeffektelementen wird für die Isolation insbesondere der Seitenflächen (31) der polykristallinen Siliciumbereiche (30) eine zusammengesetzte Isolierschicht vorgesehen. Die zusammengesetzte Isolierschicht besteht dabei vorzugsweise aus einer unmittelbar auf den polykristallinen Siliciumbereichen (30) gebildeten thermischen Siliciumdioxydschicht (24) mit einer darauf angeordneten Schicht (26) aus Phosphorsilikatglas oder aus durch chemischen Niederschlag aus der Dampfphase gebildetem Siliciumdioxyd. Behandelt sind ferner entsprechend aufgebaute Halbleiteranordnungen in Form von sog. Ladungskopplungseinrichtungen (CCD) und Ein-Element-Speicherzellenstrukturen.

Verfahren zur Herstellung von isolierten Leitbereichen aus polykristallinem Silicium sowie entsprechend aufgebaute Halbleiteranordnungen mit Feldeffektelementen

Die Erfindung befaßt sich mit dem Aufbau sowie der Herstellung von Halbleiteranordnungen mit Feldeffektelementen, z.B. in der Form von sog. Ladungskopplungseinrichtungen (CCD) und Feldeffekttransistoren (FET). Insbesondere befaßt sich die Erfindung mit Maßnahmen zur verbesserten Isolation der in solchen Anordnungen gegebenenfalls vorgesehenen mehreren Leitungsebenen, von denen mindestens eine aus polykristallinem Silicium besteht.

Die Herstellung sowie der strukturelle Aufbau von Feldeffektelementen in Form von CCD- und/oder FET-Halbleiteranordnungen, bei denen mehrere elektrisch leitfähige Lagen bzw. Ebenen für Verbindungen bzw. Elektroden vorgesehen sind, ist an sich bekannt. Statt der Verwendung metallischer Leitbereiche ist man seit einiger Zeit bekanntermaßen auch bereits bestrebt, polykristalline Siliciumbereiche (häufig auch als Polysilicium bezeichnet) vorzusehen. Für den einwandfreien Betrieb solcher Feldeffektanordnungen kommt jedoch der zuverlässigen gegenseitigen Isolation der benachbarten Leitungsebenen erhöhte Bedeutung zu. In diesem Zusammenhang traten insbesondere Probleme bezüglich der Isolation im Bereich der Seitenflächen der in einer ersten Lage gebildeten polykristallinen Siliciumbereiche von den benachbarten Bereichen in der nächsten Lage auf. Es ist zwar auch bereits bekannt, zur weitgehenden Vermeidung einiger Fehlerursachen, wie z.B. von Poren bzw. Nadellöchern oder zur Herabsetzung eines elektrischen Durchschlags, die Dicke der Isolierschicht auf dem Seitenflächen der polykristallinen Siliciumbereiche in der ersten Lage zu verstärken. Bei den konventionellen Verfahrensausgestaltungen geht damit jedoch stets eine unvermeidbare und vor allem unerwünschte Dickenzunahme auch der bereits vorgesehenen Gateoxid- bzw. Gate-Isolierschicht einher. Das Gateoxid ist gewöhnlich sehr dünn und eine Vergrößerung seiner Dicke bewirkt zwangsläufig erhebliche Verschlechterungen der resultierenden Bauelementeigenschaften.

Die vorliegende Erfindung, wie sie in den Patenansprüchen gekennzeichnet ist, löst die Aufgabe, eine dem bekannten Stand der Technik gegenüber verbesserte Isolation insbesondere hinsichtlich·der Seitenflächen der in einer ersten Lage vorgesehenen polykristallinen Siliciumbereiche bereitzustellen, ohne die oben erwähnten Nachteile einer unzuträglich erhöhten Dicke des Gateoxids in Kauf nehmen zu müssen. Als ein besonderer mit der Erfindung erzielbarer Vorteil ist es dabei anzusehen, daß durch den Einsatz einer zusammengesetzten Isolierschicht bei letztlich geringerer insgesamter Isolierschichtdicke bessere Isolationseigenschaften als im Falle des Einsatzes einer einheitlichen Isolierschicht erzielbar sind.

Die Erfindung wird im folgenden anhand von Ausführungsbeispielen unter Zuhilfenahme der Zeichnungen näher erläutert.

Es zeigen:

Fig. 1    eine schematische Querschnittsdarstellung einer derartigen Halbleiteranordnung in einem frühen Verfahrensabschnitt;

Fig. 2    eine Darstellung der Halbleiterstruktur nach einer Ätzbehandlung;

Fig. 3    eine Darstellung der Halbleiterstruktur nach der Bildung der dielektrischen Isolationszonen;

Fig. 4    eine Darstellung der Halbleiterstruktur, wie sie sich in einem späteren Verfahrenszustand ergibt;

FI 977 055

Fig. 5      eine vergrößerte ausschnittsweise Darstellung der

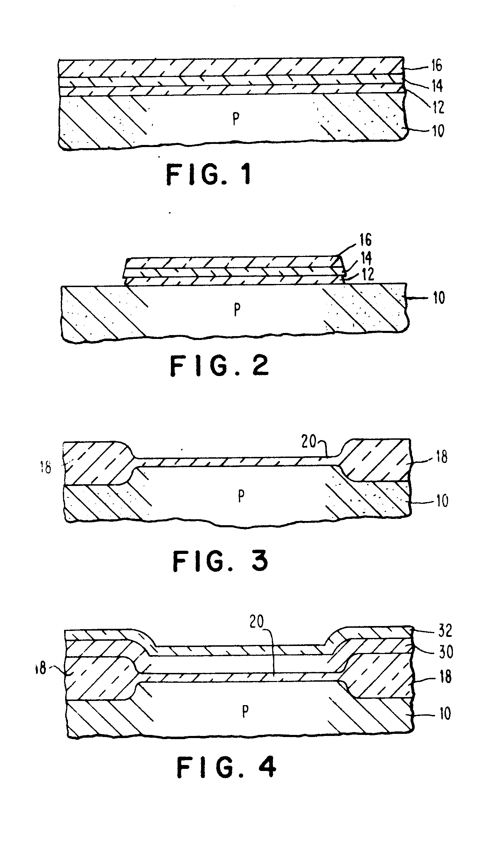

            in Fig. 4 gezeigten Struktur im Anschluß an eine
            selektive Ätzbehandlung;

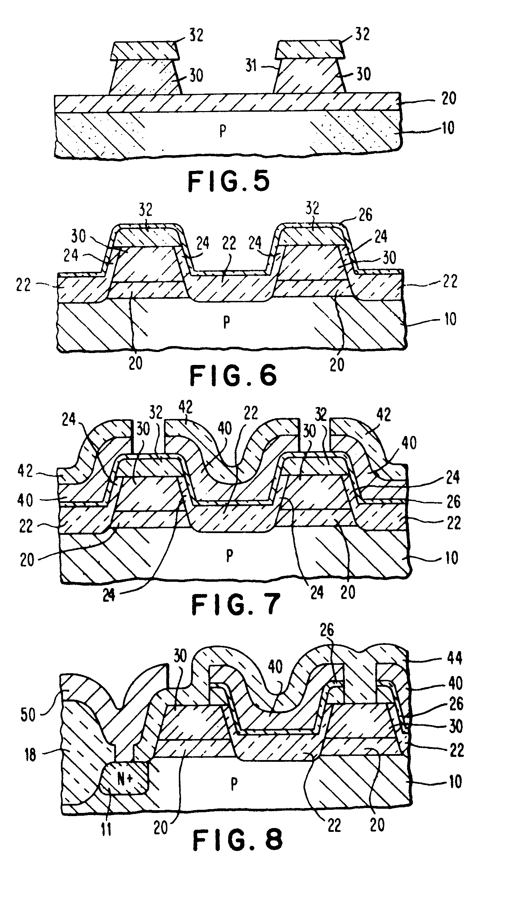

Fig. 6      eine Darstellung der Halbleiterstruktur, nachdem
            die im Rahmen der Erfindung vorgesehene zusammengesetzte Isolierschicht darauf ausgebildet ist;

Fign. 7     jeweils Darstellungen der Halbleiterstruktur, wie
  und 8      sie sich ausgehend von Fig. 6 in späteren Verfahrensstufen darstellt;

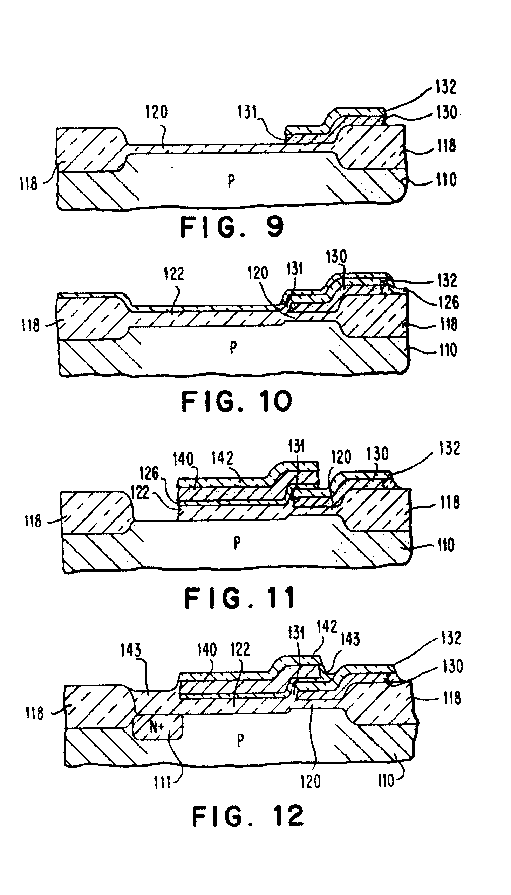

Fign. 9     eine Illustration einer Verfahrensabfolge zur im
  bis 12     Rahmen der Erfindung durchgeführten Herstellung
            einer Ein-Element-Speicherzelle.

Fig. 1 zeigt einen Ausschnitt durch ein Halbleiterplättchen
(Chip) oder eine Halbleiterscheibe (Wafer), wobei ein einkristallines Siliciumsubstrat 10 die letztlich herzustellende Struktur trägt. Dieses Substrat 10 kann P oder N dotiert
sein, je nachdem ob z.B. N- oder P-Kanal Feldeffektelemente
hergestellt werden sollen. Im Substrat können weiterhin mittels Diffusion oder Ionenimplantation gebildete Dotierungsgebiete vorgesehen sein, was für bestimmte Anwendungen, z.B.
für vergrabene Kanäle in sog. Ladungskopplungseinrichtungen,
für komplementäre Feldeffektbauelemente usw. vorteilhaft sein
kann. Da es sich insoweit um konventionelle Ausgestaltungen
handelt und die noch zu beschreibende Erfindung unabhängig
davon Anwendung finden kann, wird darauf an dieser Stelle
nicht näher eingegangen.

Das Substrat 10 wird mit einer Schicht 12 bedeckt, die gewöhnlich aus thermisch gebildeten Siliciumdioxyd besteht.
Das thermische Siliciumdioxyd wird gebildet, indem man die
Oberfläche des Siliciumsubstrats eine Sauerstoff enthaltenden

- 4 -

Dampfatmosphäre bei erhöhter Temperatur aussetzt und eine Umwandlung der Siliciumatome in Siliciumdioxyd-Verbindungen bewirkt. Die Schicht 12 aus thermischem Siliciumdioxyd wird anschließend mittels einer Schicht 14 aus Siliciumnitrid ($Si_3N_4$) bedeckt, auf die ihrerseits wieder eine Schicht 16 aus chemisch aus der Dampfphase niedergeschlagenem Siliciumdioxyd (im folgenden auch CVD-Schicht genannt) aufgebracht wird. Diese mit 16 bezeichnete Schicht kann gleichermaßen auch mittels Kathodenzerstäubung (Sputtern), pyrolytischem Niederschlag oder mittels anderer Verfahren aufgebracht werden, bei denen die Siliciumdioxydmoleküle vor ihrem Niederschlag gebildet werden. Die in Fig. 1 gezeigte Halbleiterstruktur wird anschließend mittels standardmäßig ausgestalteter Photolithographietechniken weiterbehandelt, um die in Fig. 2 gezeigte Struktur zu erhalten. Dabei bildet ein Photolack die Maskierungsschicht, um zunächst die CVD-Schicht 16 zu ätzen. Diese derart formgeätzte CVD-Schicht 16 maskiert dann ihrerseits die Struktur für den Ätzprozeß der Nitridschicht 14 bis zur thermischen Oxydschicht 12. Bei einer alternativen Prozeßausgestaltung wird die Photolackschicht direkt auf der Nitridschicht 14 aufgebracht und diese dann mittels eines Plasma-Ätzverfahrens abgetragen. Ein Eintauchätzen beseitigt dann die freigelegten Bereiche der Schicht 12, wobei nur ein relativ unbedeutender Teil (etwa 1/3) der Schicht 16 mitentfernt wird.

Die in Fig. 2 gezeigte Halbleiterstruktur wird dann zur Bildung der Oxydisolationszonen einem Oxydationsschritt unterworfen. Die Bildung solcher Oxydisolationszonen ist an sich in vielfältiger Weise bereits als bekannt anzusehen. Im Rahmen dieses Ausführungsbeispiels wird bevorzugt der Weg eingeschlagen, wonach die aus Fig. 2 ersichtlichen freigelegten Bereiche ohne vorheriges Ätzen des Substrats oxydiert werden. Während dieses Oxydationsschrittes dringen Sauerstoffatome in die freiliegenden Oberflächenbereiche des Substrats 10 ein und bewirken eine Umwandlung des dort befindlichen Siliciums in Siliciumdioxydbereiche, die in Fig. 3 mit 18 bezeichnet sind. Das auf diese Weise resultierende Siliciumdioxyd wächst sowohl in Richtung in das Substrat 10 hinein als auch auf der Substratfläche nach oben. Im Anschluß an diesen Oxydationsschritt werden mittels eines Eintauchätzvorgangs die Schichten 16, 14 und 12 bis auf die Oberfläche des Substrats 10 hin entfernt. Die Entfernung der Schicht 12 ist dabei nicht unbedingt erforderlich; wenn sie jedoch entfernt wird, läßt man anschließend eine neue Schicht 20 für das sog. Gate-Oxid auf der freigelegten Oberfläche des Substrats 10 aufwachsen, vgl. die daraus resultierende Struktur entsprechend Fig. 3. Die an Ort und Stelle gebildeten und mit 18 bezeichneten Siliciumdioxydbereiche verbleiben dabei als dickes sog. Feldoxid.

Aus Fig. 4 ist ersichtlich, daß anschließend die resultierende Struktur mit einer Schicht 30 aus polykristallinem Silicium (Polysilicium) bedeckt wird, auf die ihrerseits eine Schicht 32 aus CVD-Oxid aufgebracht wird. Der Abstand zwischen zwei Feldoxidbereichen 18 kann dabei recht groß sein. Beispielsweise können zwischen zwei solchen Isolationsbereichen 18 Hunderte von CCD-Schieberegisterstufen vorgesehen werden.

Zur näheren Erläuterung der vorliegenden Erfindung soll nunmehr auf Fig. 5 Bezug genommen werden, in der lediglich ein kleiner Ausschnittsbereich aus dem zwischen den Isolationsbereichen 18 liegenden Gebiet vergrößert dargestellt ist. Die in Fig. 5 gezeigte Halbleiterstruktur wird durch selektives Ätzen zunächst der CVD-Oxidschicht 32 mittels einer Photolackmaske erzielt. Anschließend wird unter Einsatz der CVD-Oxidschicht 32 als Maske das Polysilicium 30 bis hinunter auf das Gate-Oxid 20 geätzt. Bei diesem Ätzen des Polysiliciums 30 wird auch ein Teil des Materials unter der mas-

FI 977 055

kierenden Oxidschicht 32 entfernt, so daß die in Fig. 5 mit 31 bezeichnete Unterätzung auftritt.

Eine derartige Unterätzung 31 sowie das Erfordernis der Isolation dieser ersten Polysiliciumlage 30 gegenüber anschließend vorzusehenden elektrisch leitfähigen Ebenen wirft das mit der vorliegenden Erfindung zu lösende besondere Problem auf. Eine bekannte Lösungsmöglichkeit dafür würde darin bestehen, die Seitenflächen 31 der Schichtbereiche 30 mit einer sehr dicken Oxydationsschicht zu überziehen. Eine solche Vorgehensweise würde jedoch bewirken, daß auch freiliegende Bereiche der Oxidschicht 20 ebenfalls dicker würden. Da diese Schichten aber später als Gate-Oxid für die endgültig gebildeten Bauelemente dienen, würde damit der unvermeidliche Nachteil relativ schlechter Bauelementeigenschaften hinzunehmen sein. Es wäre zwar denkbar, diese freiliegenden Bereiche der Schicht 20 zu entfernen, um für das mit einer übermäßigen Gate-Oxiddicke zusammenhängende Problem Abhilfe vorzusehen, in der Praxis hat sich jedoch ergeben, daß eine Oxidschicht von so ausreichender Dicke, daß die Seitenflächen der ersten Polysiliciumlage 30 zuverlässig isoliert werden, stets in einer unzulässig dicken Oxidschicht resultieren. Es ist daher davon auszugehen, daß auf die zuletzt geschilderte Weise eine praktikable Lösung des genannten Problems nicht oder nicht in befriedigendem Ausmaß erreichbar ist.

Im Rahmen dieser Erfindung ist zur Lösung dieses Problems nun vorgesehen, eine Struktur der in Fig. 5 illustrierten Art mit einer zusammengesetzten Isolierschicht zu bedecken. Es wurde gefunden, daß eine zusammengesetzte Isolierschicht eine verbesserte Isolation der Seitenflächen solcher Polysiliciumbereiche 30 ergibt, ohne in einer unzulässig dicken Gate-Oxidschicht 20 zu resultieren.

FI 977 055

Im Rahmen einer Ausführungsform nach der Erfindung wird eine Halbleiterstruktur der in Fig. 5 illustrierten Art einer Phosphorpentoxid ($P_2O_5$)-Dampfatmosphäre ausgesetzt. Dadurch wird eine Schicht aus Phosphorsilikatglas (PSG) steuerbarer Dicke und Konzentration gebildet. Der hauptsächlichste Effekt ergibt sich auf den freigelegten Seitenflächen 31 der Polysiliciumbereiche 30, wo ein großer Teil des Silicium in mit Phosphor dotiertes Siliciumdioxyd (z.B. PSG) umgewandelt wird. In einem geringeren Ausmaß wird eine PSG-Schicht auch über der CVD-Schicht 32 und über dem Gate-Oxid 20 gebildet, indem Phosphoratome in die Oberfläche der vorher existierenden Oxidschicht eindringen. Ein anschließender thermischer Oxydationsschritt bewirkt ein Eindringen der Sauerstoffatome in die PSG-Schicht, wodurch die Fertigstellung der zusammengesetzten Isolierschicht abgeschlossen wird.

Die sich so ergebenen Verhältnisse sind anhand Fig. 6 veranschaulicht. Der aus einer zusammengesetzten Schichtung bestehende isolierende Überzug enthält die mit der PSG-Schicht 26 bedeckte thermische Oxidschicht 24. Während des thermischen Oxydationsschrittes wird das Gate-Oxid 20 in den mit 22 bezeichneten Bereichen zwar auch etwas dicker werden, jedoch zu einem viel geringerem Ausmaß als das der Fall sein würde, wenn die Isolation der Seitenflächen der Polysiliciumbereiche 30 nur aus einer Oxidschicht 24 entsprechender Dicke bestünde. Gegenüber einer einschichtigen Isolationsschicht sind letztlich insgesamt bessere Isolationseigenschaften bei zudem geringerer Gesamtdicke mittels einer zusammengesetzten Isolierschicht erzielbar.

Die anhand von Fig. 6 illustrierte Halbleiterstruktur kann gleichermaßen dadurch erzielt werden, daß man zunächst die in Fig. 5 gezeigte Struktur thermisch oxydiert. Indem man diese Struktur dann anschließend einer Phosphorpentoxid-Dampfatmosphäre unterwirft, erzeugt man die PSG-Schicht 26.

FI 977 055

Obwohl die erste der beiden oben beschriebenen Ausgestaltungen im allgemeinen vorzuziehen sein wird, ergibt sich in beiden Fällen die resultierende Struktur entsprechend Fig. 6.

Schließlich besteht eine weitere Verfahrensausgestaltung noch darin, daß die mit 24 bezeichneten thermischen Oxidbereiche durch Oxydation der in Fig. 5 gezeigten Struktur erzeugt werden, worauf eine durchgehende (d.h. nicht selektive) Niederschlagung einer CVD-Schicht anstelle der PSG-Schicht 26 vorgenommen wird. Die daraus resultierende Schicht 26 (aus CVD anstelle PSG) würde dann zusammen mit der Schicht 24 die gewünschte zusammengesetzte Isolierschicht darstellen.

Zu diesem Zeitpunkt im Rahmen des Herstellungsgangs kann die in Fig. 6 dargestellte Struktur mit einer weiteren Leitebene ausgestattet werden, die von der ersten Polysiliciumlage 30 zuverlässig isoliert ist. Eine solche weitere Leitebene kann entsprechend Fig. 7 aus einer zweiten Polysiliciumlage 40 bestehen. Es ist bekannt, diese zweite Polysiliciumlage 40 durch eine starke N Dotierung relativ gut leitfähig auszubilden. Diese zweite Polysiliciumlage 40 wird dann gewöhnlich mit einer weiteren isolierenden Oxidschicht 42 bedeckt, die zur Isolation dieser Schicht 40 von evtl. nachträglich aufzubringenden Schichten dient. Da solche nachfolgenden Schichten keinen direkten Feldeffekt auf die Übertragung von Elektronen oder Defektelektronen im Substratmaterial ausüben, kann die mit 42 bezeichnete Schicht gewöhnlich konventionell ausgestaltet werden.

Als nächstes mag es wünschenswert sein, einzelne Bereiche innerhalb der zweiten Polysiliciumlage 40 voneinander zu isolieren. Dies ist gewöhnlich z.B. beim Entwurf von CCD-Halbleiterstrukturen der Fall, wo langgestreckte Polysilicium-Leiterzüge 30 und 40 senkrecht zur Darstellungsebene von Fig. 7 verlaufen, um die parallele Ladungsübertragung in einer großen Anzahl von Schieberegistern zu steuern. Zur entsprechenden Formbildung der zweiten Polysiliciumlage 40 wird zunächst mittels standardmäßiger photolithographischer Verfahren die Oxidschicht 42 (selektiv) entfernt und darauf ihrerseits als Maske beim Ätzen des Polysiliciums in der Schicht 40 bis zur PSG-Schicht 26 hinunter benutzt. Die sich daraus ergebende Struktur ist in Fig. 7 illustriert.

Fig. 8 zeigt einen Ausschnitt aus einer an den Oxidisolationsbereich 18 angrenzenden Schieberegisterstruktur, wodurch der Aufbau einer für die Einleitung von Ladungen vorgesehenen Halbleiterstruktur erläutert werden soll. Um die in Fig. 8 gezeigte Halbleiterstruktur zu erhalten, wird die in Fig. 7 gezeigte Anordnung mit einer durchgehenden Oberflächenpassivierungsschicht 44 bedeckt, die aus thermischem Oxid, chemisch aus der Dampfphase niedergeschlagenem Oxid oder einer Kombination daraus bestehen kann. In dieser Schicht 44 werden anschließend selektiv Löcher geätzt und metallische Kontakte, z.B. mittels der Aluminiumschicht 50 zum N+ Diffusionsgebiet 11 hergestellt. Gleichzeitig werden in der Nähe des Endes der Schieberegisterstruktur selektiv Anschlüsse zu den Polysiliciumlagen 30 und 40 vorgesehen. Das N+ Dotierungsgebiet 11 wird im allgemeinen mittels Diffusion oder Ionenimplantation nach Ausbildung der in Fig. 7 dargestellten Halbleiterstruktur erzeugt. Ebenfalls zur gleichen Zeit erfolgt eine richtungsbestimmende Ionenimplantation zum Betrieb der Ladungskopplungseinrichtung entsprechend einem Typ eines Zweiphasen-Schieberegisters. Da diese Verfahrensschritte nicht in unmittelbarem Zusammenhang mit der vorliegenden Erfindung stehen, erübrigt sich an dieser Stelle eine nähere Erläuterung.

Statt zur Herstellung von Ladungskopplungseinrichtungen, wie anhand der Fign. 5 bis 8 dargestellt, eignet sich das im

FI 977 055

Rahmen dieser Erfindung vorgeschlagene Verfahren vorteilhaft auch zur Herstellung anderer Typen von Feldeffektelementen, z.B. Feldeffekttransistoren. Dazu wird angenommen, daß der Abstand zwischen den in Fig. 9 mit 118 bezeichneten und teilweise in das Substrat versenkten Oxidbereichen ausreichend groß zur Aufnahme einer Feldeffekttransistorstruktur und eines Kondensators ist. Eine solche Serienanordnung eines Feldeffekttransistors und eines Kondensators wird vorteilhafterweise für sog. Ein-Element-Speicherzellen in Halbleiterspeicheranordnungen mit wahlfreiem Zugriff ausgenutzt. Das soll im folgenden anhand der verschiedene Herstellungsphasen illustrierenden Fign. 9 bis 12 näher erläutert werden. In einem ersten Verfahrensschritt wird die CVD-Schicht 132 selektiv unter Einsatz bekannter photolithographischer Verfahren geätzt und dann ihrerseits als Maskierung bei der selektiven Entfernung der ersten Polysiliciumlage 130 benutzt. Anschließend kann ggf. die Gate-Oxidschicht 120 entfernt werden, muß jedoch im Falle ihrer Entfernung anschließend erneut aufgewachsen werden. Festzustellen ist in diesem Zusammenhang, daß bezüglich der mit 131 bezeichneten Seitenfläche eine Unterätzung der CVD-Schicht 132 vorliegt, d.h. vergleichbar mit der Unterätzung in der Polysiliciumlage 30 unterhalb der CVD-Schicht 32 in der früheren Fig. 5.

Um eine ausreichende Isolation der Seitenflächen 131 von einer evtl. anschließend aufzubringenden Leitschicht zu gewährleisten, wird die in Fig. 9 dargestellte Halbleiterstruktur einer Phosphorpentoxid-Atmosphäre ausgesetzt. Dadurch bildet sich eine PSG-Schicht 126 über der gesamten Struktur. Wie aus Fig. 10 hervorgeht, durchdringt eine anschließend vorgenommene thermische Oxydation diese PSG-Schicht und oxidiert die Seitenfläche 131 der ersten Polysiliciumlage 130. Während desselben thermischen Oxydationsschritts wächst auch die Dicke des Gate-Oxids im Bereich 122, während der mit 120 bezeichnete Bereich des Gate-Oxids infolge seiner Abdeckung hinsichtlich seiner Dicke unverändert bleibt. Die Dicke des Gate-Oxid im Bereich 122 wird etwa auf die doppelte Dicke der ursprünglichen Schicht 120 anwachsen.

Anschließend werden eine zweite Polysiliciumlage 140 sowie eine CVD-Schicht 142 aufgebracht und selektiv zum Erhalt der in Fig. 11 dargestellten Halbleiterstruktur geätzt. In das Substrat 110 werden danach mittels Diffusion oder Implantation Source und Drain, z.B. in der durch das N+ Dotierungsgebiet 111 angedeutenden Weise, eingebracht, worauf die gesamte Struktur zur Bildung einer in Fig. 12 mit 143 bezeichneten Siliciumdioxydschicht erneut einer Oxydationsbehandlung unterzogen wird. Anschließend werden (nicht gezeigte) Kontaktlöcher selektiv geätzt, um metallische Anschlüsse zu den Dotierungsgebieten, z.B. 111, und den Polysiliciumlagen 130 und 140 herzustellen.

Wenn die in Fig. 12 gezeigte Halbleiterstruktur als Ein-Element-Speicherzelle benutzt wird, legt man gewöhnlich eine konstante Vorspannung an die mit 130 bezeichnete erste Polysiliciumlage an. Durch eine positive Vorspannung wird eine Anreicherung von Elektronen in dem ansonsten P leitenden Material unterhalb des Gate-Oxidbereichs 120 verursacht. Dadurch wird nicht nur eine Kapazität sondern auch das Source-Gebiet des Feldeffekttransistors gebildet. Der Kanalbereich des Feldeffekttransistors liegt dabei unterhalb des Gate-Oxidbereichs 122, während das Drain-Gebiet von dem mit 111 bezeichneten Dotierungsgebiet dargestellt wird. Der Feldeffekttransistor wird ein- und ausgeschaltet, indem man selektiv entsprechende Potentiale an das Gate (welches Teil der mit 140 bezeichneten zweiten Polysiliciumlage ist) sowie über (nicht dargestellte) Metallkontakte an das Drain-Gebiet 111 anlegt.

FI 977 055

- 12 -

Wie aus der Beschreibung der geschilderten Ausführungsbeispiele hervorgeht, liefert die Erfindung eine verbesserte Isolation zwischen mehreren Leitungsebenen. Im engeren Sinne ist dazu eine zuverlässige Isolierung der in Fig. 5 mit 31 bezeichneten Seitenfläche einer ersten Polysiliciumschicht 30 gegenüber einer anschließend vorzusehenden zweiten Polysiliciumschicht erforderlich. Dasselbe Problem ergibt sich bei der in Fig. 9 dargestellten Ausführungsform hinsichtlich der mit 131 bezeichneten Seitenfläche der ersten Polysiliciumlage 130. Im Rahmen der Erfindung wird zur Lösung des geschilderten Problems die Bildung einer zusammengesetzten Isolierschicht vorgeschlagen, die sich insbesondere über den genannten Seitenflächen der ersten Polysiliciumlage erstrecken soll. Eine solche zusammengesetzte Schicht hat darüber hinaus zur Folge, daß etwaig vorhandene Poren bzw. Nadellöcher in der ersten der beiden Schichten bei der Bildung der zweiten der beiden Schichten verschlossen werden. Ein weiterer Vorteil einer solchen zusammengesetzten Schicht besteht darin, daß an der Grenzfläche zwischen den beiden Schichten Ladungsfangstellen gebildet werden, die eine Elektronenwanderung verhindern. Insgesamt wird durch eine derart zusammengesetzte Isolierschicht eine Verbesserung der dielektrischen Eigenschaften in dem Sinne erreicht, daß sowohl Durchbruchserscheinungen aufgrund der elektrischen Feldstärke als auch Leckströme wesentlich reduziert werden. Das gilt gleichermaßen für die im einzelnen geschilderten Verfahrensalternativen.

Im Rahmen einer ersten Ausgestaltung des Verfahrens wird eine Struktur der in Fig. 5 gezeigten Art für etwa 8 bis 15 Minuten bei einer Temperatur von etwa 800 bis 870$^O$ C einer Phosphorpentoxid ($P_2O_5$)-Atmosphäre ausgesetzt. Diese Phosphorpentoxidatmosphäre wird in typischen Fällen aus einer $POCl_3$-Quelle hergeleitet. Daraus resultiert eine etwa 20 nm dicke Phosphorsilikatglas (PSG)-Schicht auf den mit 31 bezeichneten Seitenflächen. Freiliegende Bereiche des Gate-Oxids 20 und der CVD-Oxidschicht 32 erhalten dabei dünnere PSG-Auflagen, soweit Phosphoratome diese freiliegenden Oxidoberflächen durchdringen. Festzustellen ist, daß zu diesem Zeitpunkt alle einkristallinen Siliciumoberflächenbereiche zur Verhinderung unerwünschter N Dotierungen maskiert sind. Die resultierende mit einer PSG-Schicht überzogene Halbleiterstruktur wird anschließend bei ungefähr 970 bis 1050° C für etwa 15 bis 40 Minuten in einer trockenen Sauerstoffatmosphäre oxydiert. Dadurch wird bewirkt, daß Sauerstoffatome die PSG-Schicht durchdringen und das Material auf den Seitenflächen 31 der ersten Polysiliciumlage 30 in situ in Siliciumdioxyd umwandeln. Dieses an Ort und Stelle umgewandelte Oxid 24 kann dabei so eine ausreichende Dicke haben, daß es den Unterätzungsbereich auffüllt, so daß die in Fig. 6 gezeigte Struktur entsteht. Einige der Sauerstoffatome dringen auch in die PSG-Schicht über dem Gate-Oxid 20 und sogar in dieses hinein, so daß die Gate-Oxiddicke im Bereich 22 etwas zunehmen kann. Zwischen der Dicke des Oxids 24 und des Gate-Oxids 22 besteht eine Beziehung derart, daß jedes von beiden mit zunehmender Temperatur und Reoxydationszeit dicker wird. Das Oxid 24 nimmt jedoch schneller in seiner Dicke zu als das Gate-Oxid im Bereich 22, weil die erste Polysiliciumlage für die Sauerstoffatome eher zugänglich ist als das Substrat unter dem Gate-Oxid. Wegen der verbesserten Isolationseigenschaften der zusammengesetzten Isolierschicht, die aus dem Oxid 24 und der PSG-Schicht 26 gebildet wird, kann der thermische Reoxydationsschritt minimal gehalten werden, wodurch sich eine nur minimale Dickenzunahme des Gate-Oxids 22 ergibt.

Entsprechend einer zweiten Ausgestaltungsmöglichkeit des Verfahrens im Rahmen der Erfindung wird die Verfahrensschrittfolge der Bildung der PSG-Schicht sowie der Oxydation umgekehrt. Demzufolge wird eine Struktur der in Fig. 5 gezeig-

FI 977 055

ten Art nunmehr in einem ersten Verfahrensschritt in der oben im einzelnen erläuterten Weise oxydiert. Dabei wird nicht nur die Seitenfläche 31 oxydiert sondern auch das Gate-Oxid 20 nimmt in den Bereichen, in denen es freiliegt, etwas an Dicke zu. Ebenfalls in der oben näher erläuterten Weise wird anschließend die PSG-Schicht gebildet. Wie aus Fig. 6 ersichtlich ist, weist diese PSG-Schicht eine im wesentlichen gleichmäßige Dicke auf, da die Phosphoratome jeweils in die Oberflächenbereiche der zuvor vorliegenden Oxidschicht eindringen. Die resultierende zusammengesetzte Isolierschicht besteht demnach aus einem Bereich 24 von an Ort und Stelle umgewandeltem Siliciumdioxyd, das mit einer PSG-Schicht 26 bedeckt ist, mithin aus einer mit den zuvor beschriebenen Verfahren erzielbaren identischen Struktur.

Gemäß einer dritten Verfahrensausgestaltung, auf die oben bereits eingegangen war, wird die zusammengesetzte Isolierschicht aufgebaut aus einer Schicht aus thermischem Oxid gefolgt von einer Schicht aus durch chemischen Niederschlag aus der Dampfphase gebildetem Oxid. Für eine Struktur der in Fig. 6 gezeigten Art heißt das beispielsweise, daß eine thermische Oxidschicht 24 mit einer Dicke in der Größenordnung von etwa 25 nm gebildet wird. Darauf folgt eine größenordnungsmäßig etwa 50 bis 75 nm dicke Schicht 26 aus CVD-Oxid. Hinzuweisen ist in diesem Zusammenhang darauf, daß die Darstellung in den Figuren insoweit natürlich nicht maßstäblich ist. Bei dieser Verfahrensausgestaltung wird die durch chemischen Niederschlag aus der Dampfphase gebildete Schicht 26 in der Regel dicker sein als die thermische Oxidschicht 24.

Die beschriebenen drei Möglichkeiten der Verfahrensausgestaltungen lassen sich statt auf Strukturen der anhand der Fig. 5 und 6 beschriebenen Art gleichermaßen anwenden auf Strukturen der anhand der Fig. 9 und 10 beschriebenen Art.

FI 977 055

Die mit 130 bezeichnete Polysiliciumlage wird bezüglich ihrer kritischen Seitenfläche 131 in situ zu einer Siliciumdioxydschicht oxydiert. Nach den beiden ersten Verfahrensmöglichkeiten befinden sich schließlich auf der Halbleiterstruktur, wie sie in Fig. 10 veranschaulicht ist, eine mit 126 bezeichnete PSG-Schicht. Bei Anwendung der dritten Verfahrensausgestaltung besteht die mit 126 bezeichnete Schicht demgegenüber aus einem CVD-Oxid.

FI 977 055

P A T E N T A N S P R Ü C H E

1. Verfahren zur Herstellung von isolierten Leitbereichen aus polykristallinem Silicium in Halbleiteranordnungen mit Feldeffektelementen, bei dem auf einem von einer ersten Isolationsschicht (z.B. 20 in Fig. 5) bedeckten Siliciumsubstrat (10) in aufeinanderfolgenden und gegeneinanderisolierten Lagen jeweils Muster aus polykristallinen Siliciumbereichen (30, 40) aufgebracht werden, dadurch gekennzeichnet,
daß im Anschluß an die Ausbildung der polykristallinen Siliciumbereiche (30) in der ersten Lage eine insbesondere die Seitenflächen (31) der polykristallinen Siliciumbereiche (30) bedeckende, aus mindestens zwei Schichten (z.B. 24, 26 in Fig. 6) zusammengesetzte Isolierschicht gebildet wird, auf die dann die nächste Lage (z.B. 40 in Fig. 7) aus leitendem Material aufgebracht wird.

2. Verfahren nach Anspruch 1, gekennzeichnet durch folgenden Verfahrensablauf für die Bildung der zusammengesetzten Isolierschicht:

   - die insoweit ausgebildete Halbleiterstruktur (z.B. Fig. 5) wird zunächst einer Phosphor- und Sauerstoffatome enthaltenden Dampfatmosphäre zur Bildung einer Schicht (z.B. 26 in Fig. 6) aus Phosphorsilikatglas (PSG) ausgesetzt;

   - anschließend wird die daraus resultierende Halbleiterstruktur einer thermischen Oxydationsbehandlung unterworfen bei der Sauerstoffatome durch die Schicht (26) aus Phosphorsilikatglas bis zum darunterliegenden polykristallinen Silicium (30) vordringen können und zwischen dem polykristallinem Silicium (30) und der

FI 977 055

Schicht (26) aus Phosphorsilikatglas durch teilweise Umwandlung des polykristallinen Siliciums eine weitere Schicht (24) aus Siliciumdioxyd bilden.

3. Verfahren nach Anspruch 1, gekennzeichnet durch folgenden Verfahrensablauf für die Bildung der zusammengesetzten Isolierschicht:

- die insoweit ausgebildete Halbleiterstruktur (z.B. Fig. 5) wird zunächst einer thermischen Oxydationsbehandlung unterworfen mittels der auf der Oberfläche und durch teilweise Umwandlung der polykristallinen Siliciumbereiche (z.B. 30 in Fig. 6) eine Schicht (24) aus Siliciumdioxyd erzeugt wird;

- anschließend wird die daraus resultierende Halbleiterstruktur einer Phosphor- und Sauerstoffatome enthaltenden Dampfatmosphäre zur Bildung einer Schicht (26) aus Phosphorsilikatglas (PSG) über der zuvor erzeugten Schicht (24) aus Siliciumdioxyd ausgesetzt.

4. Verfahren nach Anspruch 1, gekennzeichnet durch folgenden Verfahrensablauf für die Bildung der zusammengesetzten Isolierschicht:

- die insoweit ausgebildete Halbleiterstruktur (z.B. Fig. 5) wird zunächst einer thermischen Oxydationsbehandlung unterworfen, mittels der auf der Oberfläche und durch teilweise Umwandlung der polykristallinen Siliciumbereiche (z.B. 30 in Fig. 6) eine Schicht (24) aus Siliciumdioxyd erzeugt wird;

- anschließend wird auf die resultierende Halbleiterstruktur eine durch chemischen Niederschlag aus der Dampfphase gebildete Siliciumdioxydschicht auf die

FI 977 055

zuvor erzeugte Schicht (24) aus thermisch gebildetem Siliciumdioxyd niedergeschlagen.

5. Verfahren nach einem der vorhergehenden Ansprüche, dadurch gekennzeichnet,
daß die thermische Oxydationsbehandlung etwa 15 bis 40 Minuten lang bei erhöhter Temperatur im Bereich von etwa 970 bis 1050$^{O}$ C durchgeführt wird.

6. Verfahren nach Anspruch 2 oder 3, dadurch gekennzeichnet,
daß die Behandlung in einer Phosphor- und Sauerstoffatome enthaltenden Dampfatmosphäre bei einer erhöhten Temperatur im Bereich von etwa 800 bis 870$^{O}$ C vorgenommen wird.

7. Halbleiteranordnung mit Feldeffektelementen und isolierten Leitbereichen aus polykristallinem Silicium, insbesondere hergestellt nach einem der in den vorhergehenden Ansprüchen gekennzeichneten Verfahren, dadurch gekennzeichnet,
daß wenigstens auf die Seitenflächen (z.B. 31 in Fig. 5) der in einer ersten Lage isoliert auf dem Halbleitersubstrat (10) angeordneten polykristallinen Siliciumbereiche (30) eine zusammengesetzte Isolierschicht (z.B. 24, 26 in Fig. 6) vorgesehen ist, über der sich wenigstens teilweise in einer zweiten Lage weitere elektrisch leitende Schichtbereiche erstrecken.

8. Halbleiteranordnung nach Anspruch 7, dadurch gekennzeichnet,
daß die in einer zweiten Lage vorgesehenen elektrisch leitenden Schichtbereiche polykristalline Siliciumbereiche (z.B. 40 in Fig. 7) sind.

FI 977 055

- 4 -

9. Halbleiteranordnung nach Anspruch 7 oder 8, dadurch gekennzeichnet,
daß die zusammengesetzte Isolierschicht eine erste durch teilweise Umwandlung des polykristallinen Siliciums erzeugte Schicht (z.B. 24 in Fig. 6) aus Siliciumdioxyd sowie eine darüber angeordnete Schicht (26) aus Phosphorsilikatglas (PSG) umfaßt.

10. Halbleiteranordnung nach Anspruch nach 7 oder 8, dadurch gekennzeichnet,
daß die zusammengesetzte Isolierschicht aus einer durch teilweise Umwandlung des polykristallinen Siliciums thermisch erzeugten sowie einer darauf durch chemischen Niederschlag aus der Dampfphase gebildeten Siliciumdioxydschicht besteht.

FI 977 055

FIG. 1

FIG. 2

FIG. 3

FIG. 4

FIG. 5

FIG. 6

FIG. 7

FIG. 8

FIG. 9

FIG. 10

FIG. 11

FIG. 12

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| P | US - A - 4 097 314 (RCA CORP.)<br>* Spalte 5, Zeilen 34 bis 46; Fig. 11 und 12 *<br>-- | 1,4,5 7 |
| | US - A - 3 881 180 (TEXAS INSTRUMENTS)<br>* Spalte 3, Zeilen 25 bis 54; Fig. 1 *<br>-- | 1,2 |
| A | GB - A - 1 440 643 (HITACHI)<br>* Seite 2, Zeilen 102 bis 117; Fig. 2 *<br>-- | 1,3,4, 5 |
| A | DE - A - 2 027 588 (RCA CORP.)<br>* Anspruch 1; Seiten 3 bis 5 *<br>-- | 3,6 |
| A | DE - A - 2 431 917 (BBC)<br>* Anspruch 1 *<br>-- | |
| A,P | IBM Technical Disclosure Bulletin, Volume 21, Nr. 3, August 1978, New York,<br>V.L. RIDEOUT "Fabricating low resistance interconnection lines and FET gates in a single step"<br>* Seiten 1250 bis 1251 *<br>---- | |

**KLASSIFIKATION DER ANMELDUNG (Int.Cl.²)**

H 01 L 21/316
H 01 L 21/88
H 01 L 23/48

**RECHERCHIERTE SACHGEBIETE (Int. Cl.²)**

H 01 L 21/31
H 01 L 21/88
H 01 L 23/48
H 01 L 27/10
H 01 L 29/76

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort<br>Berlin | Abschlußdatum der Recherche<br>07-08-1979 | Prüfer<br>ROTHER |
|---|---|---|

EPA form 1503.1  06.78